# EUROPÄISCHE PATENTSCHRIFT

(11) **EP 0 618 759 B1**
(45) Veröffentlichungstag und Bekanntmachung des Hinweises auf die Patenterteilung: **04.09.1996**
(21) Anmeldenummer: 94104639.3
(22) Anmeldetag: 24.03.1994
(51) Int. Cl.: H05K 7/14

(54) **Gerät der Steuer-, Mess-, Regel- und/oder Datenverarbeitungstechnik**
Apparatus for controlling, measuring, regulating, and data processing techniques
Appareil de commande, mesure, réglage et traitement de données

(30) Priorität: 31.03.1993 DE 4310488
(43) Veröffentlichungstag der Anmeldung: 05.10.1994
(73) Patentinhaber: Licentia Patent-Verwaltungs-GmbH, D-60596 Frankfurt (DE)
(72) Erfinder: Ferling, Klaus, D-42579 Heiligenhaus (DE); Gloddek, Egbert, D-40877 Ratingen (DE); Matt, Achim, D-47057 Duisburg (DE)
(74) Vertreter: Erbacher, Alfons, Dipl.-Ing.

(56) Entgegenhaltungen:
- DE-U- 9 114 294
- GB-A- 2 223 884
- US-A- 4 695 920

## Beschreibung

Die Erfindung bezieht sich auf ein Gerät der Steuer-, Meß-, Regel- und/oder Datenverarbeitungstechnik mit einem Gehäuse, das ein Strangprofil mit U-förmigem Querschnitt aufweist, dessen nach vorne gerichtete offene Seite mit einem Deckel verschlossen ist und das zwei Winkelbleche enthält, die auf zwei zueinander entgegengesetzten Gehäuseseiten wahlweise in einer Position für die Gehäusebefestigung an einem rückwärtigen Tragteil oder in einer Position für die Gehäusebefestigung in einer Aussparung eines Tragteils anbringbar sind.

Es ist bereits ein Magazin für Steckkarten mit elektronischen Bauelementen bekannt, das einstückig in Preß- oder Spritzverfahren hergestellt ist und Nuten zur Führung der Steckkarten enthält. Das Magazin besitzt eine Bodenplatte mit Durchlaßöffnungen für elektrische Anschlüsse, zwei Seitenwände mit Vorsprüngen zur Aufnahme einer Abdeckung und zwei Stirnflächen. An einer Seite des Gehäuses befindet sich eine abdeckbare Öffnung zum Einschieben der Steckkarten in die Nuten des Gehäuseinneren (DE-AS 15 41 423).

Bekannt ist auch ein Gehäuse zum Einbau von elektrischen oder elektronischen Bauelementen, das aus einem Aluminiumstrangprofil und zwei stirnseitig vorgesehenen Seitendeckeln besteht. Das Strangprofil ist im Querschnitt U-förmig ausgebildet und enthält parallel zueinander verlaufende Längsnuten. In die der offenen Seite des U-Profils benachbarten Längsnuten ist eine Frontplatte einschiebbar NZ (DE-U 80 27 160).

Der Erfindung liegt das Problem zugrunde, ein Gerät der eingangs beschriebenen Art dahingehend weiterzuentwickeln, daß unabhängig von der Verbindung mit einem rückseitigen Tragteil oder mit einem Tragteil, das eine Aufnahmeöffnung für das Gehäuse aufweist, externe Leitungen schnell und einfach mit Anschlüssen am Gehäuse verbunden werden können.

Das Problem wird erfindungsgemäß dadurch gelöst, daß jeweils auf mindestens einer dieser Gehäuseseiten eine Messerleiste vorgesehen ist, mit der interne Leitungen für externe Anschlüsse des Geräts verbunden sind, daß auf die Messerleiste eine Schraubklemmkontaktleiste aufgesteckt ist, die Durchlaßöffnungen für die externen Leitungen aufweist, die bei aufgesteckten Schraubklemmkontakten in Längsrichtung der Messer der Messerleiste verlaufen, und daß die Schraubklemmkontaktleiste in Kammern, in die die Durchlaßöffnungen einmünden, von einer Seite aus zugängliche Schrauben für die Klemmkontakte aufweist und wahlweise in um 180° gedrehten Stellungen auf die Messerkontakte aufsteckbar ist. Die externen Leitungen können bei dieser Vorrichtung in die von den Messerkontakten gelösten Schraubklemmkontaktleisten eingeführt werden. Da die Schraubklemmkontaktleisten immer so in die Messerleisten eingefügt werden können, daß die Schraube in die von den Befestigungsteilen abgewandten Richtungen zeigen, können die Schrauben bei bereits mit dem Tragteil verbundenem Gerät angezogen werden, d. h. der Anschluß oder das Lösen von externen Drähten bei ortsfest installierten Geräten ist ohne Schwierigkeiten möglich. Das Gerät zeichnet sich darüber hinaus durch einfachen Aufbau aus. Drei Wände werden vom Strangprofil gebildet, das im Inneren Nuten für Leiterplatten aufweisen kann.

Bei einer zweckmäßigen Ausführungsform sind zwei Messerleisten jeweils auf Platten angeordnet, die je auf den einander entgegengesetzten offenen Seiten des Strangprofils befestigt sind und an denen jeweils die Winkelbleche angeschraubt sind. Die Platten mit den Messerleisten und Winkelblechen können als vorgefertigte Einheit am Strangprofil befestigt werden. Es entfallen daher aufwendige Bearbeitungsschritte am Strangprofil. Es ist günstig, wenn die Messerleisten auf ihren, dem Gehäuseinneren zugewandten Seiten Stifte aufweisen, die mit Leiterbahnen einer Leiterplatte verbunden sind, die in Nuten des Strangprofils geführt wird. Diese Ausführungsform läßt sich kostengünstig fertigen.

Vorzugsweise ist die Leiterplatte mit beiden Messerleisten verbunden und mit wenigstens zwei Schlitzen versehen, die sich teilweise im Abstand voneinander überlappen. Die Messerleisten können bei dieser Ausführungsform über die Platten fest mit dem Strangprofil und der Leiterplatte verbunden sein. Aufgrund der sich überlappenden Schlitze in der Leiterplatte paßt sich diese den unterschiedlichen Wärmeausdehnungskoeffizienten des Leiterplatten- und Strangprofilmaterials an.

Bei einer anderen bevorzugten Ausführungsform ist die Öffnung zwischen den freien Enden der Schenkel des Strangprofils durch einen anschraubbaren Deckel verschließbar, der auf seiner Gehäuseinnenseite mit Abstandsbolzen versehen ist, auf denen eine weitere Leiterplatte mit elektronischen Bauelementen befestigt ist, wobei Leiterbahnen der Leiterplatte über einen Steckverbinder und ein Kabel mit Leiterbahnen der an die Messerleiste bzw. Messerleisten angeschlossenen Leiterplatte verbunden sind. Das Kabel ist zweckmäßigerweise ein Flachbandkabel. Der Deckel kann zu Prüfzwecken vom Strangprofil abgenommen werden, wobei die Verbindung über das Flachbandkabel zur anderen Leiterplatte bedarfsweise gelöst werden kann, um den Deckel mit den daran befestigten Teilen vollständig vom Strangprofil zu trennen. Nach der Abnahme des Deckels ist das Gehäuseinnere leicht zugänglich.

Bei einer besonders günstigen Ausführungsform, die eigenständigen erfinderischen Gehalt hat, ist vorgesehen, daß die Messerleiste ein quaderförmiges Gehäuse aufweist, von dessen Mitte in Längsrichtung die Messer vorspringen, und daß die Schraubklemmkontaktleiste ein Gehäuse enthält, das formschlüssig in das Gehäuse der Messerleiste eingreift und Kammern aufweist, in die jeweils die Messer hineinragen, und die mit Öffnungen versehen sind, durch die die Messer wenigstens an einer Breitseite für Drahtenden zugänglich sind, wobei in den Kammern Rahmenelemente quer zu den Messern mittels der in den Kammern drehbar angeordneten, über Gehäuseöffnungen zugängliche Schrauben verschiebbar sind und wobei die Rahmenelemente die Drahtenden und die Messer umgeben und in Endlagen einstellbar sind, in denen jeweils die Drahtenden gegen die Messer angedrückt sind.

Der aus der Messerleiste und der Schraubklemmkontaktleiste bestehende Steckverbinder hat nicht nur den Vorteil, daß die Schraubklemmkontaktleiste in zwei um 180° verschiedenen Positionen wahlweise auf der Messerleiste aufgesteckt werden kann, sondern den weiteren Vorteil, daß Haltekräfte der Schraubklemmkontaktleiste an der Messerleiste durch Anpressen der Drahtenden an den Messern aufgebracht werden. Es sind deshalb keine weiteren Befestigungsmittel wie Schrauben, Muttern, Bohrungen usw. notwendig. Durch die Einsparung zusätzlicher Befestigungsmittel ergeben sich auch kleinere Abmessungen des Steckverbinders.

Vorzugsweise sind die Messer Teile von flachen Metallstreifen, die auf ihren dem Gehäuseinneren abgewandten freien Abschnitten um 90° gegenüber der Breitseite der Messer gedreht und hinter der Verdrehungsstelle um etwa 90° abgebogen sind und jeweils mindestens einen Stift für das Einfügen in ein Leiterplattenloch und ein Messerkontakt für den Anschluß an einen Steckschuh aufweisen. Auf der Gehäuseinnenseite können daher Leiterbahnen der Leiterplatte ebenso wie flexible Leitungen, deren Enden mit Steckschuhen versehen sind, an eine Kontaktstelle der Messerleiste angeschlossen werden. Daher sind auch Leiterverzweigungen möglich. Auf der Gehäuseinnenseite sind insbesondere zwischen den Metallstreifen isolierte Zwischenwände vorgesehen.

Die oben beschriebene Vorrichtung eignet sich insbesondere für Schutzeinrichtungen und/oder Netzleiteinrichtungen von elektrischen Energieverteilungsnetzen. Bei derartigen Einrichtungen müssen Wandlersekundärgrößen erfaßt und ausgewertet werden, die Spannungen in der Größe der Netzspannung oder darüber haben bzw. größere Stromstärken aufweisen. Für die von den Wandern zu den Erfassungs- bzw. Auswerteinheiten führenden Leitungen sind gewisse Querschnitte vorgeschrieben. Die Spannungen legen bestimmte Luft- und Kriechstrecken fest, die bei der Bemessung der Steckverbinder berücksichtigt werden müssen. Mit dem oben beschriebenen Steckverbinder lassen sich die Anforderungen an die Anschlußmöglichkeit von Drahtenden mit größeren Querschnitten und hinreichenden Luft- und Kriechstrecken zwischen spannungsführenden Metallteilen erfüllen. Auch die Leiterbahnen auf der Leiterplatte können entsprechende Abstände voneinander aufweisen und mit größeren Querschnitten versehen sein.

Es ist auch möglich, eigene Leitungen zwischen den Kontakten der Messerleiste und elektrischen Bauteilen im Gehäuseinneren, z. B. Trenntransformatoren, zu verlegen, die auf der Leiterplatte montiert sind.

Die Erfindung wird im folgenden anhand eines in einer Zeichnung dargestellten Ausführungsbeispiels näher beschrieben, aus dem sich weitere Einzelheiten, Merkmale und Vorteile ergeben.

Es zeigen:
- Fig. 1: ein Gerät mit elektronischen oder elektrischen Bauelernenten von außen in perspektivischer Ansicht;
- Fig. 2: das in Fig. 1 dargestellte Gerät im Längsschnitt;
- Fig. 3: eine mit einer Platte des Geräts gern. Fig. 1 verbundene Messerleiste in Seitenansicht;
- Fig. 4: einen Steckverbinder des Geräts gem. Fig. 1 in perspektivischer Ansicht, teilweise im Schnitt;
- Fig. 5: die Messerleiste gern. Fig. 3 mit einer aufgesteckten Schraubklemmkontaktleiste im Querschnitt und
- Fig. 6: ein Teil einer im Inneren des Geräts gern. Fig. 1 angeordneten Leiterplatte.

Ein Gerät 1, das eine Schaltungsanordnung mit elektrischen und/oder elektronischen Bauelernenten der Steuer-, Meß-, Regel- und/oder Datenverarbeitungstechnik enthalten kann, hat ein Gehäuse 1, das ein Strangprofil 2 mit U-förmigem Querschnitt enthält. Das Strangprofil 2 besteht vorzugsweise aus Aluminium und bildet drei Wände des Gehäuses 1. Das Gerät ist insbesondere so montiert, daß die Wände des Strangprofils senkrecht verlaufen. Die obere U-förmige Öffnung des Strangprofils 2 ist durch eine Platte 3 abgedeckt, die mittels Schrauben 4 am Strangprofil 2 angeschraubt ist. Die Schrauben 4 sind selbstfurchend in nicht dargestellte Bohrungen eingesetzt, die sich im Strangprofil 2 befinden. Die Schrauben formen beim Eindrehen in die Gewindebohrungen Gewindegänge, ohne daß Späne entstehen. Die untere U-förmige Öffnung des Strangprofils 2 ist durch eine weitere Platte 5 abgedeckt, die ebenfalls mittels Schrauben 4 am Strangprofil 2 angeschraubt ist. Zwischen den Platten 3 und 5 und den Stirnseiten des Strangprofils 2 sind jeweils Dichtungen 6, 7 angeordnet. Die vordere Öffnung des Strangprofils 2 ist durch einen Deckel 8 abgedeckt, der mit Schrauben 9 am Strangprofil 2 angeschraubt ist.

Bedarfsweise kann der Deckel 8 vom Strangprofil 2 nach dem Lösen der Schraubverbindungen entfernt werden. Zwischen dem Deckel 8 und den Schenkeln des Strangprofils 2 ist eine weitere Dichtung 10 angeordnet. Da die Spalte zwischen dem Strangprofil 2 und den Platten 4, 5 bzw. dem Deckel 8 abgedichtet sind, hat das Gehäuse 1 eine hohe Schutzart, z. B. IP51.

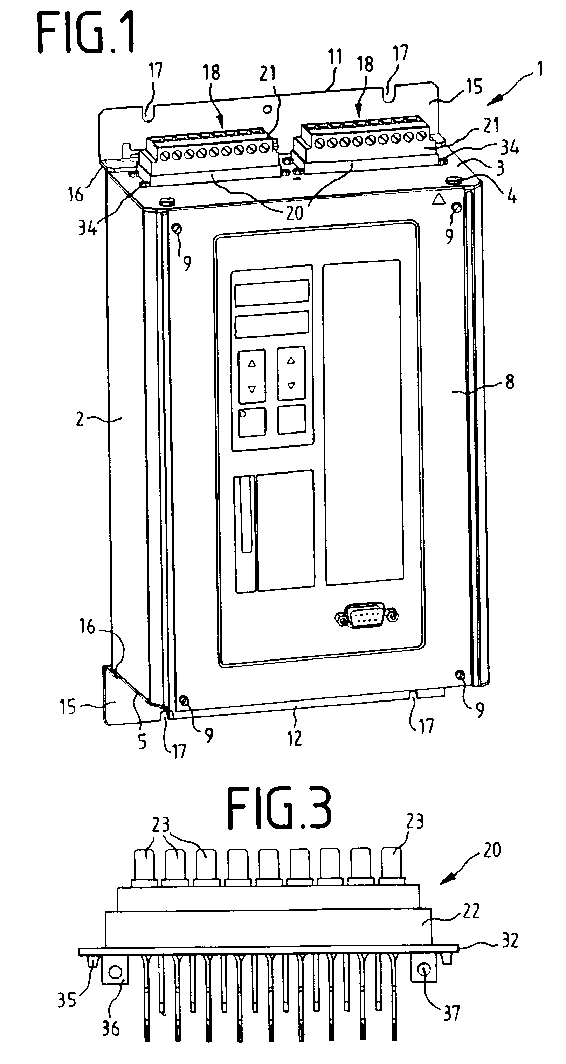

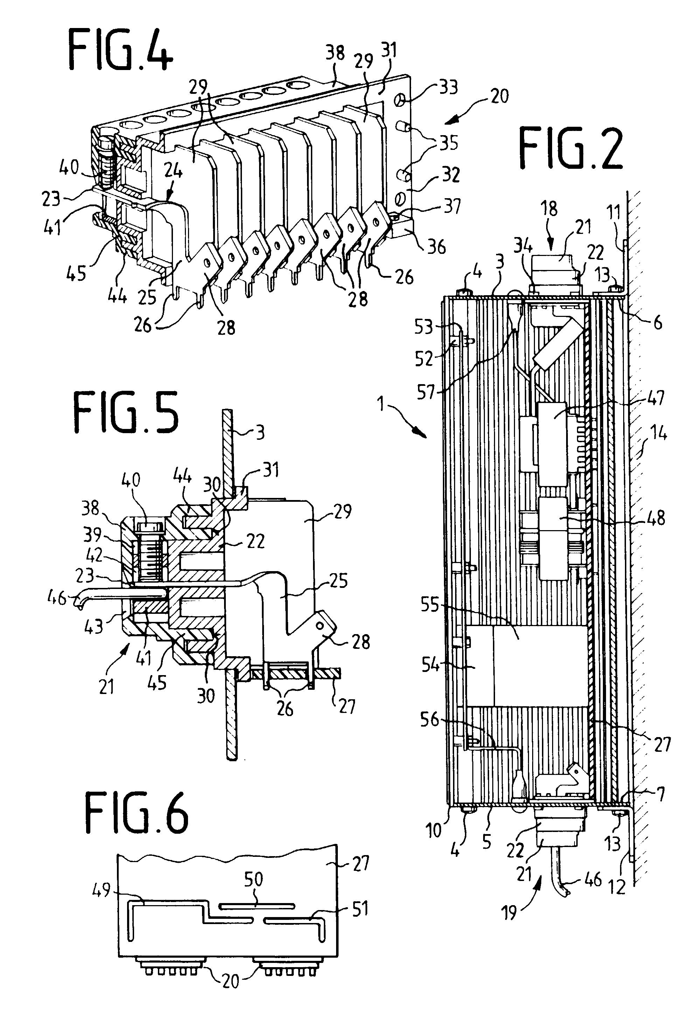

Auf den Platten 3, 4 sind jeweils Befestigungswinkel 11, 12 angeordnet. Die Befestigungswinkel 11, 12 sind mittels Schrauben 13, die durch Bohrungen der Platten 3, 4 hindurchgehen, an dem Strangprofil angeschraubt. Die Schrauben 13 werden zugleich zum Befestigen der Platten 3, 4 am Strangprofil 2 verwendet. Die Fig. 1 und 2 zeigen das Gehäuse 1 mit einer Stellung der Befestigungswinkel 11, 12, die für die rückseitige Montage des Geräts an einem Tragteil 14 geeignet ist, das nur in Fig. 2 dargestellt ist. Das Tragteil 14 ist z. B. eine Wand eines Schaltschranks.

Die Befestigungswinkel 11, 12 weisen jeweils zwei rechtwinklig zueinander verlaufende Leisten 15, 16 auf. Die Leisten 16 liegen jeweils auf einer der Platten 3, 4 auf, während die Leisten 15 gegen ein Tragteil angelehnt sind In den Leisten 15 sind Ausnehmungen 17 für das Einfügen von Befestigungsschrauben vorgesehen.

Die beiden Befestigungswinkel 11, 12 können wahlweise auch an der Vorderseite des Gehäuses 1 vorgesehen werden. In diesem Fall liegen die Leisten 16 nahe an den vorderen Rändern der Platten 3, 4 auf und sind mittels der Schrauben 4 an den Platten 3, 4 und dem Strangprofil 2 angeschraubt. Die Leisten 15 befinden sich dann in senkrechten, zueinander fluchtenden Stellungen, z. B. in der gleichen Ebene wie der Deckel 8. Das Gehäuse 1 ist daher für die rückseitige Montage und für die Montage in Aussparungen von Wänden geeignet, an deren Rändern die Leisten 15 anlegen und mittels nicht dargestellter Schrauben befestigt werden. Die Art der Befestigung richtet sich nach den Gegebenheiten am Montageort und kann dort durch die Anbringung der Befestigungswinkel 11, 12 an der Rückseite oder der Vorderseite des Gehäuses 1 noch ausgewählt werden, wenn die werkseitige Anbringung der Befestigungswinkel 11, 12 nicht den Erfordernissen am Montageort entspricht.

Für den Anschluß externer Leitungen an das Gerät sind Steckverbinder 18, 19 vorgesehen, die jeweils an der Platte 3 und 4 angebracht sind. Die Steckverbinder 18, 19 sind gleich ausgebildet. Bedarfsweise können, wie in Fig. 1 gezeigt, zwei gleiche Steckverbinder 18 nebeneinander angeordnet sein.
Die Platten 3, 4 weisen nicht näher bezeichnete Öffnungen auf, durch die Teile der Steckverbinder 18, 19 hindurchragen. Die Steckverbinder 18, 19 setzen sich jeweils aus einer Messerleiste 20 und einer Schraubklemmkontaktleiste 21 zusammen. Die Messerleisten 20 sind fest mit den jeweiligen Platten 3, 4 verbunden. Die Schraubklemmkontaktleisten 21 sind steckbar an den Messerleisten 20 befestigt und können bedarfsweise von den Messerleisten gelöst werden.

Die Fig. 3 zeigt eine Messerleiste 20 in Seitenansicht. Die Messerleiste weist ein quaderförmiges Gehäuse 22 auf, von dessen einer Seite längs der Mitte eine Reihe von Messern 23 nebeneinander vorspringen. Die Messer 23 sind jeweils Teil eines flachen Metallstreifens 24, der auf seinem dem Inneren des Gehäuses 1 zugewandten Abschnitt 25 gegenüber den Messern 23 um 90° gedreht ist und hinter der Verdrehungsstelle um 90° abgebogen ist. Die Abschnitte 25 der Metallstreifen 24 gehen an ihren Enden jeweils in zwei Stifte 26 über, die im Abstand voneinander angeordnet sind und in der gleichen Ebene verlaufen. Die Stifte 26 sind für den Einsatz in Bohrungen einer Leiterplatte 27 bestimmt, die im Inneren des Gehäuses 1 angeordnet ist. Weiterhin sind an den Enden der Abschnitte 25 jeweils Messerkontakte 28 ausgebildet, deren nicht näher bezeichnete Schmalseiten spitze Winkel mit den Schmalseiten der nicht näher dargestellten Längsachsen der Stifte 26 einschließen. Zwischen benachbarten Abschnitten 25 sind jeweils Zwischenwände 29 an der Messerleiste 20 vorgesehen. Durch die Zwischenwände 29 werden die Luft- und Kriechstrecken zwischen den Abschnitten 25 vergrößert, so daß die Messerleisten 20 für höhere Spannungen verwendet werden können.
Das quaderförmige Gehäuse 22 hat auf seiner, der Schraubklemmkontaktleiste 21 zugewandten Seite Nuten 30, die im Abstand von den Messern 23 um diese herum angeordnet sind. Entsprechend der Form der Messer 23 haben die Nuten 30 zwei parallel zu den Breitseiten der Messer 23 verlaufende Abschnitte und zwei rechtwinklig hierzu verlaufende weitere Abschnitte. Die Nuten 30 vergrößern die Luft- und Kriechstrecken.

Das Gehäuse 22 ist auf seiner der Schraubklemmkontaktleiste 21 zugewandten Seite symmetrisch in bezug auf die durch die Messer 23 verlaufenden Ebenen ausgebildet, d. h. die Nuten 30 sind in gleichen Abständen von den Messern 23 angeordnet und haben die gleiche Form und die gleichen Abmessungen.

Das Gehäuse 22 enthält eine abgewinkelt vom unteren Rand vorspringende Leiste 31, die an den Platten 3 bzw. 4 anliegt. Die Leiste 31 umgibt das Gehäuse 22 rahmenartig. An den Schmalseiten 32 sind in der Leiste 31 Löcher 33 mit Innengewinde vorgesehen, in die Befestigungsschrauben 34 eingesetzt werden. Von den Schmalseiten 32 springen kegelstumpfförmige Vorsprünge 35 vor. Auf einer Längsseite der Leiste sind nahe an den Ecken Befestigungsvorsprünge 36 mit Löchern 37 vorgesehen. An den Befestigungsvorsprüngen 36 ist die Leiterplatte 27 angeschraubt oder angenietet, in die die Stifte 26 eingelötet sind.

Die Schraubklemmkontaktleiste 21 weist ein Isolierstoffgehäuse 38 auf, das Kammern 39 enthält, in denen jeweils Schrauben 40 drehbar gelagert sind. Die Kammern 39 enthalten neben den Schrauben 40 Rahmenelemente 41, die z. B. eine rechteckige Durchlaßöffnung 42 haben. Eine Seite der Rahmenelemente 41 ist mit einer nicht näher bezeichneten Gewindebohrung versehen, in die der Gewindeabschnitt der Schraube 40 eingreift. Weiterhin sind die Kammern 39, die in aufgestecktem Zustand der Schraubklemmkontaktleisten 21 quer zu den Breitseiten der Messer 23 verlaufen, nahe an den einen Enden, die den Schraubköpfen abgewandt sind, mit Durchlaßöffnungen 43 versehen.

Eine weitere nicht näher bezeichnete Öffnung in jeder Kammer 39 ermöglicht den Zugang von außen zum Kopf der Schraube 40. Die Drehachsen der Schrauben 40 verlaufen rechtwinklig zu den Längsachsen der Messer 23. Im Bereich der Durchlaßöffnungen 43 sind die Rahmenelemente 41 in den Kammern 39 mit Hilfe der Schrauben 40 um eine gewisse Strecke verschiebbar angeordnet.
Die Gehäuse 38 enthalten auf ihren den Messerleisten 20 zugewandten Seiten rahmenartig vorspringende Leisten 44, 45. Die Leisten 45 korrespondieren mit den Nuten 30, d. h. bei zusammengefügtem Steckverbinder greifen die Leisten 45 in die Nuten 30 ein.

Die Leisten 45 umgreifen die äußeren Wände der Messerleisten 20. Hierdurch wird jeweils eine formschlüssige Verbindung zwischen den Schraubklemmkontaktleisten 21 und den Messerleisten 20 hergestellt.

Die Durchlaßöffnungen 43 erstrecken sich bis wenigstens zur Mitte des Gehäuses 38. Die Schraubklemmkontaktleisten 21 können wahlweise in zwei um 180° verschiedenen Stellungen jeweils auf die Messerleisten 20 aufgesteckt werden. Die Figuren 1 und 5 zeigen Schraubklemmkontaktleisten in der einen Stellung, in der die Köpfe der Schrauben 40 von vorne zugänglich sind. An dem Gehäuse 1, das gem. Fig. 2 an der Rückseite mit einem Tragteil verbunden ist, sind daher von vorne aus die Schraubklemmkontaktleisten 21 zugänglich. Bei aufgesteckten Schraubklemmkontaktleisten 21 können Leitungen 4, von denen in Fig. 2 und 5 nur jeweils eine Leitung 46 dargestellt ist, in die Durchlaßöffnungen 43 eingeführt und mittels der Schrauben 40 festgeklemmt werden. Wenn das Gehäuse 1 für Frontmontage mit den Befestigungswinkeln 11, 12 bestückt ist, dann werden die Schraubklemmkontaktleisten 21 gegenüber der in Fig. 1 und 2 dargestellten Position um 180° gedreht. Die Schraubklemmkontaktleisten 21 und die Schrauben 40 sind dann von der Rückseite des Geräts aus leicht zugänglich.

Die Enden von Drahtleitungen werden, wie in Fig. 5 gezeigt, in die Durchlaßöffnungen 43 und in das Innere der Rahmenelemente 41 eingeschoben. Danach werden jeweils die Schrauben 40 angezogen. Beim Anziehen der Schrauben 40 verschieben sich die Rahmenelemente 41 in Richtung der Schrauben 40, bis das jeweilige Drahtende an dem in die Rahmenelemente 41 hineinragenden Messer 23 anliegt. Die Schraube 40 wird mit einem so großen Drehmoment angezogen, daß das Drahtende fest zwischen dem jeweiligen Messer 23 und der einen Innenwand des Rahmenelements 41 angespannt wird. Durch diese Einspannung wird die Schraubklemmkontaktleiste 21 fest an den Messern 23 und damit an der Messerleiste 20 gehalten. Weitere Mittel zur Befestigung der Schraubklemmkontaktleiste 21 an der Messerleiste 20 sind deshalb nicht notwendig.

Die Rahmenelemente 41 sind mit ihren Innenraumquerschnitten an den maximal gewünschten Querschnitt der Leitungen angepaßt.

Es ist ohne weiteres möglich, die Innenraumquerschnitte für Leitungen mit 2,5 mm² und mehr auszulegen. Das oben beschriebene Gerät eignet sich daher für Anordnungen der Netzleit- und Netzschutztechnik, bei denen für die Weiterleitung bestimmter Meßgrößen, z. B. Wandlerströmen, höhere Querschnitte notwendig sind.

Die Leiterplatte 27 ist im Inneren des Gehäuses 1 in vertikalen Nuten der beiden einander gegenüberstehenden Innenwände des Strangprofils 2 geführt. Von den Stiften 26 bzw. den Lötverbindungen der Stifte 26 mit Leiterbahnen auf der Leiterplatte 27 verlaufen Leiterbahnen zu Bauelementen, die auf der Leiterplatte 27 befestigt sind. Die Fig. 2 zeigt elektrische Bauelemente 47, 48, z. B. Transformatoren, die von der Leiterplatte 27 getragen werden.

Die Fig. 6 zeigt einen Teil der Leiterplatte 27. Dieser Teil trägt an seinem Rand zwei Messerleisten 20. Im Abstand von den Messerleisten 20 sind in der Leiterplatte 27 Schlitze 49, 50, 51 vorgesehen, die sich teilweise in Abständen voneinander überlappen. Aufgrund der sich überlappenden Schlitze kann sich die Leiterplatte 27 den Wärmedehnungen des Strangprofils 2 anpassen, obwohl die Wärmeausdehnungskoeffizienten der Leiterplatte 27 und des Strangprofils 2 verschieden voneinander sind. Besonders wichtig ist auch noch, daß die Schlitze einen Toleranzausgleich der Maße zwischen der Leiterplatte und den Halteteilen der Leiterplatte ermöglichen. Die Leiterplatte 27 ist nämlich zwischen den oberen und unteren Steckverbindern 18, 19 fest mit den Platten 3, 4 und damit dem Strangprofil 2 verbunden.

Auf der Innenseite des Deckels 8 sind mehrere Abstandsbolzen 52 vorgesehen, an deren Enden eine weitere Leiterplatte 53 parallel zum Deckel 8 befestigt ist. Auf der Leiterplatte 53 befinden sich elektronische Bauelemente, z. B. Prozessoren, Speicher, Eingabe- Ausgabeschaltungen und dgl. Die Leiterplatte 53 trägt Steckverbinder 54, an die ein zu der Leiterplatte 27 verlaufendes Flachbandkabel 55 angeschlossen ist. Zwischen einer Masseleitung auf der Leiterplatte 53 und der Platte 5 ist eine Erdungsleitung 56 verlegt. Auch zwischen dem Blech des Transformators 47 und der Platte 3 ist eine Erdungsleitung 57 verlegt. Die beiden Leitungen 56, 57 sind über nicht näher bezeichnete Kabelschuhe an Steckverbinder der Platten 3, 5 angeschlossen.

Am Deckel 8 sind Anzeigeelemente und Bedienelemente, z. B. Taster, befestigt, die nicht näher dargestellt sind. Die Anzeige- und Bedienelemente sind an die Bauelemente auf der Leiterplatte 53 angeschlossen. Über den Bedienelementen ist eine Folie angebracht, die Symbole trägt, die auf die Bedienelemente hinweisen.

Das Gehäuse 1 zeichnet sich durch einen einfachen Aufbau mit wenigen Teilen aus, die keine komplizierte Form haben. Daher kann das Gehäuse 1 besonders wirtschaftlich gefertigt werden. Wegen der Möglichkeit, größere Leitungsquerschnitte ohne Quetschung der Drähte an das Gehäuse 1 anschließen zu können, eignet sich das Gehäuse 1 insbesondere für Netzleit- und Netzschutzeinrichtungen, mit denen Störungen, z. B. Erdschlüsse, Kurzschlüsse und Unterbrechungen in Energieversorgungsnetzen erfaßt werden. Die Meßgrößen werden von Strom- und Spannungswandlern abgegriffen, die über Leitungen mit dem Gehäuse 1 verbunden sind. Die Auswerteinrichtungen befinden sich im Gehäuse 1.

Durch die Anklemmung der Enden der Leitungen 46 an den in die Kammern 39 ragenden Enden der Messer 23 mittels der Schrauben 40 vereinfacht sich der Aufbau der Schraubklemmkontaktleisten 21. Die Messerleisten 20 sind vorzugsweise auf der Oberseite und/oder auf der Unterseite des Geräts 1 angeordnet. Bei dieser Anordnung werden die Enden der Leitungen 46 im wesentlichen senkrecht in die Kammern 39 eingeführt. Die Drehachsen der Schrauben 40 verlaufen dann in einer waagrechten Ebene, so daß die Schrauben 40, je nach Befestigung des Geräts an einer Tafel oder einer rückwärtigen Wand, gut zugänglich sind. Durch die gemeinsame Einklemmung der Enden der Leitungen 46 und der Messer 23 mittels der Schrauben 40 lassen sich Federleistenanschlüsse vermeiden.

Durch die oben beschriebene Anordnung der Messerleiste 20 und der in besonderer Weise für den Einbau in zueinander um 180° gedrehten Stellungen ausgebildeten Schraubklemmkontaktleiste 21 ist es möglich, mit einfachen Mitteln eine Verdrahtung der äußeren Leitungen am Gerät 1 je nach der Gerätebefestigungsart von der vorderen Seite oder der Rückseite durchzuführen.

Geräte 1 können deshalb am Einbauort ohne vorherige Einstellung in der Fabrik an die Gegebenheiten einer vorderen oder rückseitigen Befestigung angepaßt und schnell und einfach in der Einbaulage lediglich durch die richtige Drehstellung der Schraubklemmkontaktleiste 21 an externe Leitungen angeschlossen werden. Von besonderer Bedeutung für diese Flexibilität ist die rechtwinklige Verschieberichtung der Schrauben 40 gegenüber den Messerleisten 20 und die gemeinsame Anordnung von Messern und Drahtenden in einer Klemmverbindung mit Schrauben sowie die Eigenschaft der Schraubklemmkontaktleisten 21, in um 180° gedrehten Stellungen an den Messerleisten befestigbar zu sein.

Am Deckel 8 sind Anzeigeelemente und Bedienelemente, z. B. Taster, befestigt, die nicht näher dargestellt sind. Die Anzeige- und Bedienelemente sind an die Bauelemente auf der Leiterplatte 53 angeschlossen. Über den Bedienelementen ist eine Folie angebracht, die Symbole trägt, die auf die Bedienelemente hinweisen.

Das Gehäuse 1 zeichnet sich durch einen einfachen Aufbau mit wenigen Teilen aus, die keine komplizierte Form haben. Daher kann das Gehäuse 1 besonders wirtschaftlich gefertigt werden. Wegen der Möglichkeit, größere Leitungsquerschnitte ohne Quetschung der Drähte an das Gehäuse 1 anschließen zu können, eignet sich das Gehäuse 1 insbesondere für Netzleit- und Netzschutzeinrichtungen, mit denen Störungen, z. B. Erdschlüsse, Kurzschlüsse und Unterbrechungen in Energieversorgungsnetzen, erfaßt werden. Die Meßgrößen werden von Strom-und Spannungswandlern abgegriffen, die über Leitungen mit dem Gehäuse 1 verbunden sind. Die Auswerteinrichtungen befinden sich im Gehäuse 1.

## Patentansprüche

1. Gerät der Steuer-, Meß-, Regel- und/oder Datenverarbeitungstechnik mit einem Gehäuse, das ein Strangprofil (2) mit U-förmigem Querschnitt aufweist, dessen nach vorne gerichtete offene Seite mit einem Deckel (8) verschließbar ist und das zwei Winkelbleche (11, 12) enthält, die auf zwei zueinander entgegengesetzten Gehäuseseiten wahlweise in einer Position für die Gehäusebefestigung an einen rückwärtigen Tragteil oder in einer Position für die Gehäusebefestigung in einer Aussparung eines Tragteils anbringbar sind,
**dadurch gekennzeichnet,**
daß jeweils auf wenigstens einer dieser Gehäuseseiten eine Messerleiste (20) vorgesehen ist, mit der interne Leitungen für externe Anschlüsse des Geräts verbunden sind, daß auf die Messerleiste (20) eine Schraubklemmkontaktleiste (21) aufgesteckt ist, die Durchlaßöffnungen (43) für externe Leitungen (46) aufweist, die bei aufgesteckten Schraubklemmkontaktleisten (21) in Längsrichtung der Messer (23) der Messerleiste (20) verlaufen, und daß die Schraubklemmkontaktleiste (21) in Kammern (42), in die die Durchlaßöffnungen (43) einmünden, von einer Seite aus zugängliche Schrauben (40) für die Klemmkontakte aufweist und wahlweise in um 180° gedrehten Stellungen auf die Messerleiste (20) aufsteckbar ist.

2. Gerät nach Anspruch 1,
**dadurch gekennzeichnet,**
daß zwei Messerleisten (20) jeweils auf Platten (3, 5) angeordnet sind, die je auf einander entgegengesetzten offenen Seiten des Strangprofils (2) befestigt sind.

3. Gerät nach Anspruch 1 oder 2,
**dadurch gekennzeichnet,**
daß die Messerleisten (20) auf ihren, dem Gehäuseinneren zugewandten Seiten Stifte (26) aufweisen, die mit Leiterbahnen einer Leiterplatte (27) verbunden sind, die in Nuten des Strangprofils (2) geführt ist.

4. Gerät nach einem oder mehreren der vorhergehenden Ansprüche,
**dadurch gekennzeichnet,**
daß die Leiterplatte (27) mit den beiden Messerleisten (20) verbunden ist und mit wenigstens zwei Schlitzen (49, 50) versehen ist, die sich teilweise im Abstand voneinander überlappen.

5. Gerät nach einem oder mehreren der vorhergehenden Ansprüche,
**dadurch gekennzeichnet,**
daß die Öffnung zwischen den freien Enden der Schenkel des Strangprofils (2) durch einen aufschraubbaren Deckel (8) verschließbar ist, der auf seiner Gehäuseinnenseite mit Abstandsbolzen (52) versehen ist, auf denen eine weitere Leiterplatte (53) mit elektronischen Bauelementen befestigt ist, und daß die Leiterbahnen der Leiterplatte (53) über einen Steckverbinder (54) und ein Kabel (55) mit Leiterbahnen der an die Messerleisten (20) angeschlossenen Leiterplatte (27) verbunden sind.

6. Gerät nach einem oder mehreren der vorhergehenden Ansprüche,
**dadurch gekennzeichnet,**
daß die Messerleiste (20) ein quaderförmiges Gehäuse aufweist, von dessen einer Seite in der Mitte in Längsrichtung die Messer (23) vorspringen, und daß die Schraubklemmkontaktleiste (21) ein Gehäuse enthält, das formschlüssig in das Gehäuse der Messerleiste (20) verbunden ist und Kammern (39) aufweist, in die jeweils die Messer (23) hineinragen und die mit den Durchlaßöffnungen (43) versehen sind, durch die die Messer (23) wenigstens an einer Breitseite für das Anlegen von Drahtenden zugänglich sind, daß in den Kammern (39) Rahmenelemente (41) quer zu den Messern mittels der in den Kammern drehbar angeordneten Schrauben (40) verschiebbar sind und daß die Rahmenelemente (41) die Drahtenden und die Messer (23) in Endlagen aneinanderpressen.

7. Gerät nach Anspruch 6,
**dadurch gekennzeichnet,**
daß die Messer (23) Teile von flachen Metallstreifen (24) sind, die auf ihren den Messern (23) abgewandten freien Abschnitten (25) um 90° gegenüber der Breitseite der Messer (23) gedreht und hinter der Drehstelle um etwa 90° abgebogen sind und jeweils mindestens einen Stift (26) für das Einfügen in ein Leiterplattenloch aufweisen.

8. Gerät nach Anspruch 7,
**dadurch gekennzeichnet,**
daß zusätzlich zu dem Stift (26) ein Messerkontakt (28) am Ende des Abschnitts (25) angeordnet ist.

9. Gerät nach einem oder mehreren der Ansprüche 6 bis 8,
**dadurch gekennzeichnet,**
daß zwischen den Abschnitten (25) Zwischenwände (29) vorgesehen sind.

10. Gerät nach einem oder mehreren der vorhergehenden Ansprüche,
**dadurch gekennzeichnet,**
daß im Gehäuse (22) der Messerleiste (20) jedes Messer (23) von einer Nut (30) umgeben ist, deren Abschnitte im Abstand vom jeweiligen Messer (23) parallel zu dessen Seiten verlaufen, und daß in jede Nut (30) eine Leiste (44) einsetzbar ist, die vom Gehäuse (38) der Sch Schraubklemmkontaktleiste (21) vorspringt.

## Claims

1. Apparatus of the controlling, measuring, regulating and/or data processing technology, with a housing which comprises an extrusion (2) with U-shaped cross-section, the forwardly oriented open side of which is closable by a cover (3) and which comprises two angle brackets (11, 12), which are mountable on two mutually opposite housing sides selectably in a position for fastening of the housing to a rearward support member or in a position for fastening of the housing in a cutout of a support member, characterised thereby that provided on at least one of these housing sides is a respective blade strip (20), with which internal leads for external connections of the apparatus are connected, that plugged onto the blade strip (20) is a screw clamping contact strip (21), which has passage openings (43) for external leads (46) which extend in longitudinal direction of the blades (23) of the blade strip (20) when the screw clamping contact strip (21) is plugged on, and that the screw clamping contact strip (21) comprises screws (40), which are accessible from one side in chambers (42) into which the passage openings (43) open, for the clamping contacts and is pluggable onto the blade strip (20) selectably in settings turned through 180°.

2. Apparatus according to claim 1, characterised thereby that two blade strips (20) are arranged respectively on plates (3, 5), which are respectively fastened on mutually opposed open sides of the extrusion (2).

3. Apparatus according to claim 1 or 2, characterised thereby that the blade strips (20) have Dins (26) on their sides facing the housing interior, which pins are connected with conductor tracks of a circuitboard (27), which is guided in grooves of the extrusion (2).

4. Apparatus according to one or more of the preceding claims, characterised thereby that the circuitboard (27) is connected with the two blade strips (20) and is provided with at least two slots (49, 50), which partly overlap at a spacing from one another.

5. Apparatus according to one or more of the preceding claims, characterised thereby that the opening between the free ends of the limbs of the extrusion (2) is closable by a lid (8) which can be screwed on and which is provided on its housing inner side with spacer pins (52) on which a further circuitboard (53) with electronic components is fastened, and that the conductor tracks of the circuitboard (53) are connected by way of a plug connector (54) and a cable (55) with conductor tracks of the circuitboard (27) connected to the blade strips (20).

6. Apparatus according to one or more of the preceding claims, characterised thereby that the blade strip (20) comprises a parallelepipedonal housing, of which one side protrudes in the middle in longitudinal direction of the blades (22) and that the screw clamping contact strip (21) contains a housing, which is connected in mechanically positive manner in the housing of the blade strip (20) and has chambers (39), into which the blades (23) respectively project and which are provided with the passage openings (43), through which the blades (23) are accessible at least at a wide side for the applying of the wire ends, that in the chambers (39) frame elements (41) are displaceable transversely to the blades by means of screws (40) rotatably arranged in the chambers and that the frame elements (41) press together the wire ends and the blades (23) in end positions.

7. Apparatus according to claim 6, characterised thereby that the blades (23) are Darts of flat metal strips (24), which at their free portions (25) remote from the blades (23) are turned through 90° relative to the wide side of the blades (23) and are bent over through about 90° behind the turning point and each have at least one pin (26) for insertion into a circuitboard aperture.

8. Apparatus according to claim 7, characterised thereby that in addition to the pin (26) a blade contact (28) is arranged at the end of the portion (25).

9. Apparatus according to one or more of claims 6 to 8, characterised thereby that intermediate walls (29) are provided between the portions (25).

10. Apparatus according to one or more of the preceding claims, characterised thereby that in the housing (22) of the blade strip (20) each blade (23) is surrounded by a groove (30), the portions of which extend at a spacing from the respective blade (23) parallelly to the sides thereof, and that a strip (44), which projects from the housing (38) of the screw clamping contact strip (21), is insertable into each groove (30).

## Revendications

1. Dispositif de commande, de mesure, de régulation et/ou de traitement de données, comportant un boîtier, qui présente un profilé extrudé (2) de section transversale en U, dont le côté ouvert dirigé vers l'avant peut être fermé au moyen d'un couvercle (3) et qui contient deux cornières (11, 12), qui peuvent être appliquées sur deux côtés opposés l'un à l'autre du boîtier, au choix dans une position pour la fixation du boîtier sur un élément de support arrière ou dans une position pour la fixation du boîtier dans une découpe d'un élément de support,
caractérisé
en ce qu'il est prévu sur au moins l'un des côtés du boîtier, une réglette à lame (20) avec laquelle sont reliées des lignes internes pour des branchements externes du dispositif, en ce que sur la réglette à lame (20) est enfilée une réglette de contact de bornes à vis (21), qui présente des ouvertures de passage (43) pour des lignes externes (46), qui lorsque les réglettes de contact de bornes à vis (21) sont enfilées s'étendent dans la direction longitudinale de la lame (23) de la réglette à lame (20), et en ce que la réglette de contact de bornes à vis (21) dans des chambres (42), dans lesquelles débouchent les ouvertures de passage (43), présente des vis (40) accessibles d'un côté pour les contacts à bornes et peut être enfilée au choix sur la réglette à lame (20), dans des positions tournées de 180°.

2. Dispositif selon la revendication 1,
caractérisé
en ce que deux réglettes à lame (20) sont placées chacune sur des plaques (3, 5) qui sont fixées chacune sur des côtés ouverts opposés du profilé extrudé (2).

3. Dispositif selon la revendication 1 ou 2,
caractérisé
en ce que les réglettes à lame (20) présentent sur leurs côtés, tournés vers l'intérieur du boîtier, des broches (26) qui sont reliées avec des pistes conductrices d'une carte de circuits imprimés (27), qui est guidée dans des rainures du profilé extrudé (2).

4. Dispositif selon une ou plusieurs des revendications précédentes,
caractérisé
en ce que la carte de circuits imprimés (27) est reliée aux deux réglettes à lame (20) et est pourvue d'au moins deux fentes (49, 50), qui se recouvrent partiellement, espacées l'une de l'autre.

5. Dispositif selon une ou plusieurs des revendications précédentes,
caractérisé
en ce que l'ouverture entre les extrémités libres des branches du profilé extrudé (2) peut être fermée par un couvercle (8) vissable, qui est pourvu sur son côté intérieur au boîtier, de doigts d'écartement (52) sur lesquels est fixée une autre carte de circuits imprimés (53) avec des composants électroniques, et en ce que les pistes conductrices de la carte de circuits imprimés (53) sont reliées par un connecteur à broches (54) et un câble (55) avec des pistes conductrices de la carte de circuits imprimés (27) raccordée aux réglettes à lame (20).

6. Dispositif selon une ou plusieurs des revendications précédentes,
caractérisé
en ce que la réglette à lame (20) présente un boîtier parallélépipédique dont les lames (23) font saillie d'un côté, au milieu de la direction longitudinale, et en ce que la réglette de contact de bornes à vis (21) contient un boîtier, qui est relié par concordance de forme dans le boîtier de la réglette à lame (20) et présente des chambres (39) dans chacune desquelles pénètrent les lames (23) et qui sont pourvues d'ouvertures de passage (43), à travers lesquelles les lames (23) sont accessibles au moins sur un côté de la largeur pour l'application d'extrémités de fils, en ce que dans les chambres (39) peuvent coulisser des éléments en cadre (41), transversalement aux lames, au moyen des vis (40) disposées tournantes dans les chambres et en ce que les éléments en cadre (41) pressent l'une contre l'autre les extrémités des fils et les lames (23) dans des positions de fin de course.

7. Dispositif selon la revendication 6,
caractérisé
en ce que les lames (23) sont des parties de bandes métalliques (24) plates, qui sur leurs portions libres (25), tournées à l'opposé des lames (23), sont tournées de 90° par rapport au côté de la largeur des lames (23) et sont repliées d'environ 90°, derrière le point de rotation et présentent chacune au moins une broche (26) pour l'introduction dans un trou de la carte de circuits imprimés.

8. Dispositif selon la revendication 7,
caractérisé
en ce qu'en supplément à la broche (26) il est prévu un contact à lame (28) à l'extrémité de la portion (25).

9. Dispositif selon une ou plusieurs des revendications 6 à 8,
caractérisé
en ce que des parois intermédiaires (29) sont prévues entre les portions (25).

10. Dispositif selon une ou plusieurs des revendications précédentes,
caractérisé
en ce que dans le boîtier (22) de la réglette à lame (20) chaque lame (23) est entourée par une rainure (30), dont les portions s'étendent, à distance de la lame (23) respective, parallèlement à ses côtés, et en ce que dans chaque rainure (30) peut être insérée une réglette (44), qui dépasse du boîtier (38) de la réglette de contact de bornes à vis (21).
